# EUROPEAN PATENT SPECIFICATION

(11) **EP 2 200 077 B1**
(45) Date of publication and mention of the grant of the patent: **05.12.2012**
(21) Application number: 08291226.2
(22) Date of filing: 22.12.2008
(51) Int. Cl.: H01L 21/762

(54) **Method for bonding two substrates**
Verfahren zur Bindung zweier Substrate
Procédé pour la liaison de deux substrats

(43) Date of publication of application: 23.06.2010
(73) Proprietor: Soitec, 38190 Bernin (FR)
(72) Inventor: Castex, Arnaud, 38100 Grenoble (FR)
(74) Representative: Grünecker, Kinkeldey, Stockmair & Schwanhäusser

(56) References cited:
- EP-A- 1 662 549
- EP-A- 1 998 368
- US-A1- 2004 229 444
- US-A1- 2007 158 831

## Description

The invention relates to a method for bonding two substrates, and in particular to a method wherein at least one of the two substrates may comprise processed or at least partially processed devices. This kind of bonding situation occurs, for example, in the fabrication process of backside illuminated CMOS imager structures, when a first substrate comprising the opto-electronic devices of the CMOS imager are bonded to a second substrate. After bonding, the first substrate is thinned, preferentially by grinding, so that light can enter into the device via the backside.

During bonding, the adhesion between two substrates is achieved via molecular forces (Van de Waals forces). To achieve a high quality bonding and to facilitate the subsequent thinning step, it is mandatory to obtain a high bonding energy, at least in the range of 700 to 1000 mJ/m² or even more. In the prior art high bonding energies are obtained by heating the assembled structure, typically over 1000°C.

Unfortunately, there are situations in which it is not possible to expose the bonded assembly to high temperature. This is the case for instance if devices are present on one of the substrates, and the standard thermal treatment to improve the bonding energy cannot be carried out. Indeed, the high temperatures of about 1000 to about 1100°C in the standard thermal treatment would have negative impacts on the functioning of the devices due to, for example, the spreading out of dopant concentrations or the diffusion of metals forming the devices. Using the mentioned temperature regime, a bonding energy in a range of 1,5J/m² to 2 J/m² has been observed.

As an alternative to high temperature annealing of the bonded assembly, it has been proposed to reach high bonding energy by surface activation steps, for instance plasma activation followed by low temperature annealing, of the surfaces to be bonded as described in prior art document US 2007/0158831. However, it has been observed that these steps could lead to bond voids, like e.g. edge voids, thus defects at the bonded interface. It has furthermore been observed that the higher the bonding energy, the higher the number of edge voids. This phenomenon has a negative impact on the fabrication yield, in particular in case that the non-transferred layers comprise electronic devices.

It is therefore the object of the present invention to provide a method for bonding with which satisfying bonding energies can be achieved in the absence of a high temperature thermal treatment.

This object is achieved with the method according to claim 1. The inventive method for bonding two substrates, thus comprises the steps of a) applying an activation treatment, comprising a plasma treatment, to at least one of the two substrates, and b) performing the contacting step of the two substrates under partial vacuum.

It is the surprising finding of this invention that it is the combination of the two steps a) and b) that leads to the desired level in the bonding energy, namely of the order of 700 - 1000 mJoule/m² with a reduced number of edge voids compared to the known bonding processes. Furthermore, by only applying a partial vacuum, which can easily be reached by using standard rough pumps only, the process is fast and easy to carry out. A high bonding quality, namely no or at least with a reduced number of edge voids, can be achieved even with two substrates having thermal expansion coefficients which are so different that the standard thermal anneal methods cannot be applied. Finally, the bonding quality observed with the inventive method is sufficient to carry out a layer transfer according to the Smart Cut^{™} technology, where ions are implanted into a donor wafer to define a plane of weakness. The bonded assembly comprising the donor wafer can then be split in the absence or with a reduced number of edge defects and despite relatively low temperatures.

According to the invention, at least one of the two substrates comprises processed or at least partially processed devices.

In this context, the term "device" relates to any structure on at least one of the substrates which at least partially belongs to the final devices like electronic devices or opto-electronic devices comprising, amongst others, capacitor and/or transistor structures. It is the particular advantage of the invention that it can be applied to any bonded structure that requires high bonding energy but cannot be exposed to high temperature and/or that suffers from the presence of edge voids. This is the case when devices are present in or on one of the substrates.

According to the invention, the partial vacuum can have a pressure of 1 - 50 Torr (1,33mbar - 66,7mbar), preferably 1 - 20 Torr (1,33mbar - 26,6 mbar), preferably between 10 to 20 Torr (13,3mbar - 26,6 mbar). This level of vacuum can be easily and rapidly be reached with rough pumps, which at the same time have a cost advantage. There is thus no need to go up to a secondary vacuum to reach the desired bonding energy and a reduced level of defects.

According to the invention, step b) is be carried out at room temperature, in particular at a temperature in a range of 18 - 26°C. The possibility to carry out the contacting step which is under partial vacuum, at room temperature facilitates the practical realisation of the process.

According to the invention, after bonding and during subsequent treatment steps, the bonded substrates are exposed to temperatures of at most 500°C, preferably at most 300°C. With the inventive method, the bonding energy is high enough for the subsequent treatments and at the same a reduced number of bonding voids compared to the prior art is observed, which in turn improves the bonding. Furthermore a degradation of devices like back side imagers in already processed layers, e.g. due to diffusion of metals, fusion of metallic lines and/or contacts can be prevented.

According to a preferred embodiment, the activation treatment can comprise at least one of a polishing step, a cleaning step and a brushing step of the surface/s to be bonded. In this context, it is further preferred that the activation treatment for a substrate without processed or at least partially processed devices comprises a cleaning step, a plasma activation, a cleaning step and a brushing step, in this order. Furthermore, concerning the activation treatment for a substrate with processed or at least partially processed devices, the activation treatment can preferably comprise a polishing step and a cleaning step in this order. Further preferred, the activation treatment can further comprise a plasma activation step and/or brushing step after the cleaning. With these treatments, further optimised results concerning the bonding energy are achievable.

According to the invention, the contacting step is carried out in a dry atmosphere, in particular with less than 100 ppm H₂O molecules. The dry atmosphere further reduces the occurrence of defects, in particular of edge voids.

More advantageously, the contacting step can be carried out in a neutral atmosphere, in particular in an argon and/or nitrogen atmosphere.

According to a preferred variant, the inventive method can further comprise the step of providing a dielectric layer, in particular an oxide layer, over the processed devices wherein bonding occurs between the surface of the dielectric layer and one surface of the second substrate. This dielectric layer can, for instance, be a PECVD deposited oxide which, furthermore, is planarised to represent a surface roughness of less than 5 A RMS. Thus, bonding can be carried out independently of the topology of the processed device structures on at least one of the substrates under predetermined conditions.

According to the invention, the inventive method comprises an additional step of thinning at least one of the two substrates after bonding. As a consequence of the high bonding energy achieved and the reduced number of bonding voids according to the inventive method, it is thus possible to carry out the thinning after bonding even after a limited thermal treatment.

Finally, the invention also relates to opto-electronic devices provided on substrates fabricated according to one of the above-described methods.

Advantageous embodiments of the invention will now be described in detail with respect to the following Figures:

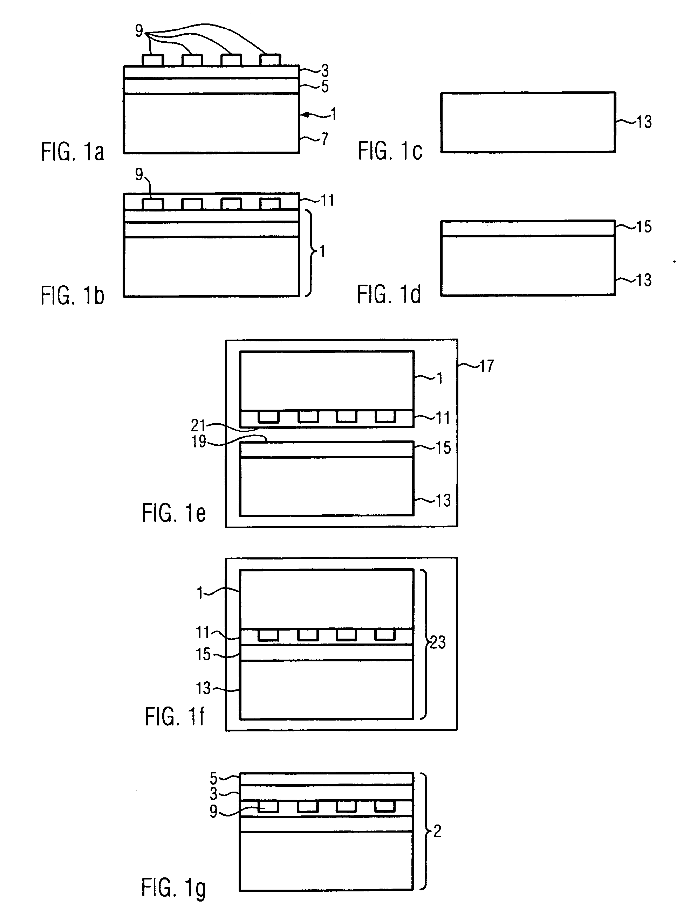

Figures 1 a -1g illustrate one embodiment of the bonding method according to the invention.
Figure 1a illustrates a first substrate 1, which is also called a donor substrate. In this embodiment, the donor substrate is a silicon on insulator wafer with a silicon layer 3 provided on a buried oxide layer 5 in turn provided on a base substrate 7, e.g. a silicon wafer. Instead of an SOI substrate, any other suitable substrate such as a plain silicon wafer, a germanium arsenide wafer or a germanium on insulator, etc. can be used as the first substrate 1. Processed devices 9, such as electronic devices or opto-electronic devices, already have been fabricated in and/or on the semiconductor layer 3 of the first substrate 1. Typically, the semiconductor layer 3, together with the devices 9, has a thickness of about 2 to 30 µm, for instance 15 µm. The devices 9 present on the first substrate 1 can be completely processed or only partially processed, meaning that, in subsequent process steps, the devices will be finalised, e.g. by provided electric connections etc.
Figure 1b illustrates the next step of the method which consists in providing a dielectric layer 11, for example an oxide, on the devices 9. The dielectric layer 11 in this embodiment is deposited using a suitable process, like plasma enhanced CVD. Following the deposition of this layer 11, a planarisation step is carried out, e.g. using chemical mechanical polishing CMP, to obtain a surface roughness of less than 5 A RMS, so that the dielectric layer 11 can serve as a leveling layer.
Figure 1c illustrates a second substrate 13, here called the support substrate, which is typically a silicon wafer, but could also be out of any other suitable material. Prior to bonding, an oxidation step is carried out to provide an oxide layer 15 on the support substrate 13 with a thickness of about 0.5 - 2.5 µm. Alternatively, the subsequent bonding is performed without any oxide formation step or by depositing the oxide on the support substrate.

The donor substrate 1 with the devices and the dielectric layer 11 and/or the support substrate 13 with its oxide layer 15, as illustrated in Figure 1d, are then activated.

In the case of the donor substrate 1 activation, first of all a further second polishing step is carried out. The removal of material is typically less than 1 micron or even less than 0.3 micron so that the surface is activated and prepared for bonding. The polishing step is followed by a cleaning step, which can for instance comprise scrubbing of the surface and SC1 cleaning to remove particles or polishing slurry residue. These steps are carried out on the surface of the dielectric layer 11, which represents the surface at which bonding will occur in the subsequent process step. In some instances, however, this polishing step can be omitted.

According to a variant, the donor substrate's activation can be complemented by a plasma activation using an O₂ and/or N₂ plasma with or without a subsequent brushing step. This step e.g. consist in the exposure of the donor substrates surface to be bonded to an oxygen plasma or a plasma containing O₂. The plasma exposure tool can be, for example, a

Reactive Ion Etching tool, with a plasma power of about 100 W to 1000 W for a 200 mm wafer and a plasma pressure of about 1 to 100mTorr (1,33mbar to 133mbar).

The support substrate 13 activation in turn consists in cleaning of the surface, for instance using SC1 30 to 80°C for about 10min, an O₂ and/or N₂ plasma activation under the same conditions as mentioned above, a further cleaning and a final brushing step of the surface of oxide layer 15 at which bonding will occur in a subsequent process step.

The role of the activation process step is to prepare the surfaces for bonding so that high bonding energies can be achieved.

Subsequently, illustrated in Figure 1e, the first and second substrates are placed into a bonding chamber 17 with the surface 19 of the oxide layer 15 on the support substrate 13 facing the surface 21 of the dielectric layer 11 on the donor substrate 1. Typically, both substrates are aligned with respect to their notches. After the introduction of the substrates and their alignment, the chamber is closed and pumped down to a vacuum in the order of 1 - 50 Torr, preferably 1 - 20 Torr, and even preferably between 10 to 20 Torr. Typically, this takes about 2 - 3 minutes and, for the purpose of the invention, this level of partial vacuum provides the increase in bonding energy in a reasonable time, e.g. compared to high or ultra high vacuum. Furthermore less sophisticated vacuum pumps, like primary rough pumps are sufficient to carry out the invention.

The atmosphere in the bonding chamber in the embodiment is essentially composed of a dry atmosphere, in particular with less than 100 ppm H₂O molecules, and/or further preferred of a neutral atmosphere, composed for instance of argon and/or nitrogen. The bonding chamber is kept at room temperature, thus in a range of 18°C to 26°C.

When the desired pressure level is reached, the two surfaces 19 and 21 are brought into contact, as illustrated in Figure 1f, and bonding is initiated. Typically, bonding starts at one point and a bonding wave spreads out so that, in the end, surfaces 19 and 21 are attached to each other via molecular adhesive forces (van der Waals forces) and form a donor-support compound 23. The initial contact can be achieved by applying a slight pressure on the side or in the centre, for instance by a mechanical finger.

With the described bonding method, due to the advantageous synergistic effects of carrying out the surface activation steps in combination with the contacting under partial vacuum, bonding energies in a range of at least 700 - 1000 mJoule/m² with a reduced level of or even without bonding defects are achieved. In addition, these results are achieved without having to carry out a post-bonding anneal at high temperatures of greater than 500°C. It has been observed that the occurrence of edge voids can be suppressed or limited (by at least one order of magnitude compared to the prior art bonding methods) except for voids arising from the presence of particles on one of the surfaces before bonding.

According to a variant of the embodiment, the donor substrate 1 can be thinned down, as illustrated in Figure 1 g. Thinning can be achieved by a grinding and/or a polishing step, followed by a chemical etch that stops on the buried oxide 5 of the initial SOI donor substrate 1. Eventually, additional finishing steps, such as edge polishing and/or grinding, can be performed. The thinning does not necessarily stop at the buried oxide 5. According to further variants, even this oxide layer 5 could also be removed. In this layer 3 and eventually 5 are transferred on the second substrate. In this case, the inventive bonding method shows further advantageous effects as, again due to the high bonding energy achieved, the edge of the transferred layer is of high quality, it shows a regular outline, no cracking or tearing off on the edge of the wafer due to the mechanical thinning of the donor wafer.

As illustrated in Figure 1g, the initial devices 9 of the SOI device layer 3 have now been transferred onto the support substrate 13. To complete the devices, additional processing steps, such as electrical connection etc, can be performed.

In addition, the structure 25 of Figure 1g might serve as a support substrate 13 in subsequent fabrication process steps. In this case, both the donor substrate and the support substrate can comprise devices.

In opto-electronic applications, the structure as illustrated in Figure 1g will receive light via the buried oxide layer 5 so that it impinges on the backside of electronic devices 9.

According to a variant, the thinning could also be achieved using a Smart Cut^{™} approach. In this case, prior to bonding, light species such as helium or hydrogen are implanted into the donor substrate 1 to form a predetermined splitting area. Splitting is then achieved during or after the exposition of the bonded 23 assembly, as illustrated in Figure 1f to higher than room temperature, e.g. in a range of 300 - 500°C.

In this embodiment the first substrate 1 carries already devices 9 on it. The invention is nevertheless not limited to this kind of situation as any substrate with our without device structures can be processed according to the invention and thus achieve high bonding energy and reduced edge void concentration.

## Claims

1. Method for bonding two substrates comprising the steps of:
a) providing processed or at least partially processed devices (9) on at least one of the two substrates (1, 13),
b) providing a dielectric layer (11) over the devices (9),
c) applying an activation treatment, comprising a plasma treatment, to at least one of the two substrates (1, 13),
d) performing a contacting step of the two substrates (1, 13) under partial vacuum, wherein the partial vacuum has a pressure of between 1 to 50 Torr (1,33 mbar-66,7 mbar), and
e) thinning at least one of the two substrates (1, 13) after bonding,
wherein step d) is carried out at room temperature, in particular at a temperature in a range of 18°C to 26°C,
wherein the contacting step is carried out in a dry atmosphere, in particular with less than 100ppm H₂O molecules, and
wherein after bonding and during subsequent treatment steps, the bonded substrates are exposed to temperatures of at most 500°C, in particular at most 300°C.

2. Method according to claim 1, wherein the activation treatment comprises at least one of a polishing step, a cleaning step and a brushing step of the surface/s to be bonded.

3. Method according to claim 2, wherein the activation treatment for a substrate without processed or at least partially processed devices (9) comprises a cleaning step, a plasma activation, a cleaning step and a brushing step in this order.

4. Method according to claim 2 or 3, wherein the activation treatment for a substrate with processed or at least partially processed devices (9) comprises a polishing step and a cleaning step in this order.

5. Method according to claim 4, wherein the activation treatment furthermore comprises a plasma activation step and/or brushing step after the cleaning.

6. Method according to one of claims 1 to 5, wherein the contacting step is carried out in a neutral atmosphere, in particular a Ar and/or N atmosphere.

7. Method according to one of claims 1 to 6, wherein bonding occurs between the surface of the dielectric layer (11) and one surface of the second substrate (13).

## Patentansprüche

1. Verfahren zum Verbinden zweier Substrate, das die folgenden Schritte umfasst:
a) Bereitstellen bearbeiteter oder wenigstens teilweise bearbeiteter Vorrichtungen (9) auf wenigstens einem der zwei Substrate (1, 13),
b) Bereitstellen einer dielektrischen Schicht (11) über den Vorrichtungen (9),
c) Anwenden einer Aktivierungsbehandlung, die eine Plasmabehandlung umfasst, auf wenigstens eines der zwei Substrate (1, 13),
d) Durchführen eines Schrittes des Kontaktierens der zwei Substrate (1, 13) im Teilvakuum, wobei das Teilvakuum einen Druck zwischen 1 und 50 Torr (1,33 mbar - 66,7 mbar) hat, und
e) Verdünnen wenigstens eines der zwei Substrate (1, 13) nach dem Verbinden,
wobei Schritt d) bei Raumtemperatur, insbesondere bei einer Temperatur in einem Bereich von 18 °C bis 26 °C, ausgeführt wird,
wobei der Schritt des Kontaktierens in einer trockenen Atmosphäre, insbesondere mit weniger als 100 ppm H₂O-Molekülen, ausgeführt wird, und
wobei nach Verbinden und während folgender Behandlungsschritte die verbundenen Substrate Temperaturen von maximal 500°C, insbesondere maximal 300°C, ausgesetzt werden.

2. Verfahren nach Anspruch 1, wobei die Aktivierungsbehandlung einen Schritt des Polierens, einen Schritt des Reinigens oder/und einen Schritt des Bürstens der zu verbindenden Oberfläche/n umfasst.

3. Verfahren nach Anspruch 2, wobei die Aktivierungsbehandlung für ein Substrat ohne bearbeitete oder wenigstens teilweise bearbeitete Vorrichtungen (9) einen Schritt des Reinigens, eine Plasmaaktivierung, einen Schritt des Reinigens und einen Schritt des Bürstens in dieser Reihenfolge umfasst.

4. Verfahren nach Anspruch 2 oder 3, wobei die Aktivierungsbehandlung für ein Substrat mit bearbeiteten oder wenigstens teilweise bearbeiteten Vorrichtungen (9) einen Schritt des Polierens und einen Schritt des Reinigens in dieser Reihenfolge umfasst.

5. Verfahren nach Anspruch 4, wobei die Aktivierungsbehandlung des Weiteren einen Schritt der Plasmaaktivierung und/oder einen Schritt des Bürstens nach dem Reinigen umfasst.

6. Verfahren nach einem der Ansprüche 1 bis 5, wobei der Schritt des Kontaktierens in einer neutralen Atmosphäre, insbesondere einer Ar- und/oder N-Atmosphäre, ausgeführt wird.

7. Verfahren nach einem der Ansprüche 1 bis 6, wobei Verbinden zwischen der Oberfläche der dielektrischen Schicht (11) und einer Oberfläche des zweiten Substrats (13) stattfindet.

## Revendications

1. Procédé pour relier deux substrats, comprenant les étapes consistant à :
a) fournir des dispositifs traités ou au moins partiellement traités (9) sur au moins l'un des deux substrats (1, 13),
b) fournir une couche diélectrique (11) au-dessus des dispositifs (9),
c) appliquer au moins à l'un des deux substrats (1, 13) un traitement d'activation, comprenant un traitement au plasma,
d) réaliser une étape de mise en contact des deux substrats (1, 13) sous un vide partiel, dans lequel le vide partiel a une pression comprise entre 1 et 50 Torr (1,33 mbar à 66,7 mbar), et
e) amincir au moins l'un des deux substrats (1, 13) après liaison,
dans lequel l'étape d) est réalisée à la température ambiante, en particulier à une température située dans la plage de 18 °C à 26 °C,
dans lequel l'étape de mise en contact est réalisée dans une atmosphère sèche, en particulier avec moins de 100 ppm de molécules de H₂O, et
dans lequel après liaison et lors des étapes de traitement suivantes, les substrats reliés sont exposés à des températures d'au plus 500 °C, en particulier au plus 300 °C.

2. Procédé selon la revendication 1, dans lequel le traitement d'activation comprend au moins une étape parmi une étape de polissage, une étape de nettoyage et une étape de brossage de la ou des surfaces à relier.

3. Procédé selon la revendication 2, dans lequel le traitement d'activation pour un substrat sans dispositifs traités ou au moins partiellement traités (9) comprend, dans cet ordre, une étape de nettoyage, une activation au plasma, une étape de nettoyage et une étape de brossage.

4. Procédé selon la revendication 2 ou 3, dans lequel le traitement d'activation pour un substrat avec dispositifs traités ou au moins partiellement traités (9) comprend, dans cet ordre, une étape de polissage et une étape de nettoyage.

5. Procédé selon la revendication 4, dans lequel le traitement d'activation comprend en outre une étape d'activation au plasma et/ou une étape de brossage après le nettoyage.

6. Procédé selon l'une des revendications 1 à 5, dans lequel l'étape de mise en contact est réalisée dans une atmosphère neutre, en particulier dans une atmosphère d'Ar et/ou de N.

7. Procédé selon l'une des revendications 1 à 6, dans lequel la liaison s'effectue entre la surface de la couche diélectrique (11) et une surface du deuxième substrat (13).
